Europäisches Patentamt

European Patent Office

Office européen des brevets

(19)

(11) EP 0 928 056 A2

(12) EUROPEAN PATENT APPLICATION

(43) Date of publication:
07.07.1999 Bulletin 1999/27

(51) Int Cl.$^6$: H02M 3/10

(21) Application number: 98309930.0

(22) Date of filing: 04.12.1998

(84) Designated Contracting States:
AT BE CH CY DE DK ES FI FR GB GR IE IT LI LU
MC NL PT SE
Designated Extension States:
AL LT LV MK RO SI

(30) Priority: 30.12.1997 US 70057 P

(71) Applicant: TEXAS INSTRUMENTS
INCORPORATED
Dallas Texas 75265 (US)

(72) Inventor: Rincon-Mora, Gabriel Alfonso, Dr.
Allen, Texas 75002 (US)

(74) Representative: Harris, Ian Richard et al
D. Young & Co.,
21 New Fetter Lane
London EC4A 1DA (GB)

(54) **Voltage loss compensation for dc-dc converters**

(57)     A DC-DC converter (100) having an input node receiving an input voltage $V_{IN}$ and an output that provides power to a load circuit. A pulse width modulation (PWM) unit (201) is coupled to chop $V_{IN}$ into a square wave under control of a $V_{DRIVE}$ signal. An output stage (207) converts the chopped $V_{IN}$ to an output voltage $V_{OUT}$ coupled to an output node (203). A parasitic impedance is coupled between the output node (203) and the load circuit as a result of resistance in the circuit board wiring and I/O pins. A reference voltage generator provides a voltage $V_{REF}$ while an offset voltage generator provides a compensation voltage representing a voltage drop across the parasitic impedance ($V_{LDR}$). A comparator unit receives $V_{OUT}$, $V_{REF}$, and $V_{LDR}$ and is coupled to the PWM unit to provide the $V_{DRIVE}$ signal.

FIG. 2

Printed by Jouve, 75001 PARIS (FR)

Description

BACKGROUND OF THE INVENTION

1. Field of the Invention.

The present invention relates, in general, to integrated circuits and, more particularly, to integrated circuits having voltage regulator circuits for DC-DC converters.

2. Relevant Background.

Integrated circuits (ICs) comprise thousands or millions of individual devices interconnected to provide desired functionality. Significant effort is expended to improve processing techniques so as to reduce the size of each individual device in order to provide greater functionality on a given IC chip at reduced cost. In general, smaller geometry devices operate faster while dissipating less power than do larger geometry devices. As device geometries are reduced the breakdown voltages of the devices and the isolation that separates the devices decreases also.

Electronic systems usually comprise ICs manufactured with a variety of technologies. This has created a need for multiple power supply voltages to be supplied on a single printed circuit board to support the various types of devices on that board. For example, some ICs require a power supply voltage of 5.0 volts while state of the art microprocessors and memory circuits require a power supply voltage of 3.3 volts, 2.8 volts or lower. Voltage regulator circuitry may be provided to decrease the higher voltage (e.g., 5.0V in the above example) to the lower voltage required by the small geometry device (e.g., 3.3 V or 2.8V). Hence, it is necessary to regulate the available power supply voltage to provide voltages consistent with that required by each of the small geometry ICs.

A conventional voltage regulator is designed to generate a lower voltage than the available supply voltage. Typically, a transistor is coupled in series between the external voltage node and the internal voltage supply node. The conductivity of the transistor is modulated to drop the excess voltage across the transistor. Linear regulators have many desirable characteristics such as simplicity, low output ripple, high quality line and load regulation, and fast recovery time. However, linear regulators are inefficient resulting in wasted power and excess heat generation.

Switching regulators are becoming more common because of their characteristic high efficiency and high power density (i.e., power-to-volume ratio) resulting from smaller magnetic, capacitive, and heat sink components. Switching regulators convert one DC voltage into another DC voltage by selectively storing energy by switching energy on and off in an inductor. By comparing the output voltage to a reference voltage ($V_{REF}$)

the inductor current is controlled to provide the desired output voltage. Switching regulators exhibit longer hold-up times than linear regulators which is a characteristic that is important in computer applications. Switching regulators accept a wider range of input voltages with little effect on efficiency making them particularly useful in battery powered applications.

Parasitic trace-path resistance ($R_{PAR}$) on circuit boards and IC leads causes significant voltage drop ($V_{LDR}$) from the actual output of the converter to the loading circuits. The problem becomes especially significant when the loading circuits require high load-currents that can result in voltage drops of several hundred millivolts. In circuits that require high accuracy this voltage drop results in inherent system error. It has thus been proposed to sense the voltage drop, for example, through sensing the load-current and characterizing the parasitic resistance $R_{PAR}$. The sensed voltage drop is used to drive an amplifier that generated an offset voltage that is added to the reference voltage to determine a new reference voltage ($V_{REF(NEW)} = V_{REF}+V_{OFFSET}$) so that the DC-DC converter regulates at the new, higher, reference voltage.

Then, the voltage at the load does not experience the load regulation effect previously described. However, the reference voltage has stringent accuracy requirements and is usually implemented with high accuracy devices such as bandgap reference circuits and the like. The addition of $V_{OFFSET}$ to the reference introduces an error to the accuracy of the reference. One of the ways the error is manifested is through buffer inaccuracy, i.e., input offset voltage, gain error, and time delay.

Another limitation of these previously proposed approaches is that the amplifier used to generate $V_{OFFSET}$ needs to be able to drive zero volts (lowest supply voltage) with high gain which is difficult to provide. This is important because at light load currents the voltage drop is near zero volts. Thus, the offset and gain error introduced significantly degrade accuracy of the reference. Moreover, this amplifier needs to be fast because any amplifier induced latencies are cumulative with the latencies of other devices in the circuit. Amplifier designs that compensate for these limitations add complexity, size, and cost to the circuit, and degrade overall performance.

SUMMARY OF THE INVENTION

Particular and preferred aspects of the invention are set out in the accompanying independent and dependent claims. Features of the dependent claims may be combined with those of the independent claims as appropriate and in combinations other than those explicitly set out in the claims.

According to a first aspect of the invention there is provided means for sensing a voltage drop ($V_{LDR}$) across the parasitic impedance(s) and either subtracting $V_{LDR}$ from the sensed output voltage ($V_{OUT}$) or adding it to the reference voltage ($V_{REF}$) at the comparator level. This obviates the need to introduce any series delay elements. Moreover, it is possible to eliminate or reduce significant errors associated with altering the sensitive reference voltage. Still further it is possible to compensate the load regulation effect of $R_{PAR}$ efficiently and with minimal adverse accuracy effects.

According to a second aspect of the invention there is provided a DC-DC converter having an input node receiving an input voltage $V_{IN}$ which converter provides power to a load circuit. A pulse width modulation (PWM) unit is coupled to chop $V_{IN}$ into a square wave under control of a $V_{DRIVE}$ signal. An output stage converts the chopped $V_{IN}$ to an output voltage $V_{OUT}$ coupled to an output node. A parasitic impedance is coupled between the output node and the load circuit as a result of resistance in the circuit board wiring and I/O pins. A reference voltage generator provides a voltage $V_{REF}$ while an offset voltage generator driven by a voltage drop across the parasitic impedance provides a voltage $V_{LDR}$. A comparator unit receives $V_{OUT}$, $V_{REF}$, and $V_{LDR}$ and is coupled to the PWM unit to provide the $V_{DRIVE}$ signal.

According to a third aspect of the invention there is provided a DC-DC converter providing power to a load circuit, the DC-DC converter comprising:

an input node receiving an input voltage $V_{IN}$;
a pulse width modulation (PWM) unit coupoled to chop $V_{IN}$ into a square wave under control of a $V_{DRIVE}$ signal;
an output stage converting the chopped $V_{IN}$ to an output voltage $V_{OUT}$ coupled to an output node;
a parasitic impedance coupled between the output node and the load circuit;
a reference voltage generator providing a voltage $V_{REF}$;
an offset voltage generator having an output coupled to provide a voltage $V_{COMP}$ representing a voltage drop accross the parasitic impedance ($V_{LDR}$); and
a comparator unit coupled to receive $V_{OUT}$, $V_{REF}$, and $V_{COMP}$ and coupled to the PWM unit to provide the $V_{DRIVE}$ signal.

According to a fourth aspect of the invention there is provided a circuit including a DC-DC converter, the circuit comprising:

an input node receiving an input voltage $V_{IN}$;
a pulse width modulation (PWM) unit coupled to chop $V_{IN}$ into a square wave under control of a $V_{DRIVE}$ signal;
a low pass filter coupled to receive the chopped VIN and generate output voltage $V_{OUT}$ coupled to an output node;
a load circuit having a node coupled to receive power

er from the output node;
conductive wiring having a parasitic impedance coupled between the output node of the low pass filter and the load circuit;
a reference voltage generator providing a voltage $V_{REF}$;
an offset voltage generator having an output coupled to provide a voltate $V_{COMP}$ representing a voltage drop accross the parasitic impedance ($V_{LDR}$); and
a comparator unit coupled to receive $V_{OUT}$, $V_{REF}$, and $V_{COMP}$ and coupled to the PWM unit to provide the $V_{DRIVE}$ signal.

In the circuit of the fourth aspect the comparator unit may further comprise: a first differential input stage generating a signal coupled to a summing node determined from a difference between $V_{OUT}$ and $V_{REF}$; and a second differential input stage generating a signal coupled to the summing node determined from the voltage drop across the parasitic impedance. Moreover, the first and second differential input stages may comprise parametrically matched components. Further, the first and second differential input stages may be arranged to operate in parallel such that time delays associated with each of the first and second differential input stages are non-cumulative. Still further, the reference voltage generator may be isolated from the offset voltage generator output. Yet still further, the comparator unit may further comprise a device for subtracting offset voltage from $V_{OUT}$ prior to providing the $V_{DRIVE}$ signal.

According to a fifth aspect of the inventon there is provided a method for providing power to a load circuit, the load circuit coupled to a regulator output node supplying an output voltage $V_{OUT}$ through a connection having a characteristic parasitic impedance, the method comprising the steps of:

providing an input voltage $V_{IN}$;
providing a reference voltage $V_{REF}$;
comparing $V_{OUT}$ to $V_{REF}$ to determine a first difference signal;
determining a loaded output voltage $V_{OUT(LOAD)}$ at the load circuit;
comparing $V_{OUT}$ to $V_{OUT(LOAD)}$ to determine a second difference signal;
subtracting the second difference signal from the first difference signal to generate a trigger signal; and
generating a pulse width modulated signal by amplifying the trigger signal.

In the step of determining a loaded output voltage $V_{OUT(LOAD)}$ the $V_{OUT(LOAD)}$ may be directly sensed.
Moreover, the step of determining a loaded output voltage $V_{OUT(LOAD)}$ may comprise:

estimating a load resistance $R_{LDR}$ coupling the

$V_{OUT}$ to $V_{OUT(LOAD)}$;

sensing a current flow level from $V_{OUT}$ to $V_{OUT(LOAD)}$; and

estimating $V_{OUT(LOAD)}$ based upon the $R_{LDR}$ and current flow level.

Further, the method of the fifth aspect may further comprise the steps of:

chopping the input voltage $V_{IN}$ into a square wave using the pulse width modulated signal; and converting the square wave into a $V_{OUT}$ using a low pass filter.

The foregoing and other features, utilities and advantages of the invention will be apparent from the following more particular description of embodiments of the invention as illustrated in the accompany drawings.

BRIEF DESCRIPTION OF THE DRAWINGS

FIG. 1 illustrates a portion of an embodiment of the present invention schematically;

FIG. 2 illustrates an exemplary implementation for generating offset voltages in accordance with an embodiment of the present invention;

FIG. 3 shows a voltage diagram illustrating switching behaviour of a comparator in accordance with an embodiment of the present invention;

FIG. 4 illustrates an exemplary CMOS implementation in accordance with an embodiment of the present invention;

FIG. 5 illustrates an exemplary CMOS implementation in accordance with an alternative embodiment of the present invention; and

FIG. 6 shows an example output stage which may be used in combination with a hysteretic comparator of FIG. 4 or FIG. 5.

DETAILED DESCRIPTION

Specific embodiments of the present invention are described in the following in terms of a hysteretic DC-DC converter where the accuracy and speed of the comparator are paramount. However, in a more general sense other embodiments of the present invention may be realised in a variety of comparator circuits where it is desirable to allow a user to compensate for some offset voltage without impacting the speed or accuracy of the comparator function.

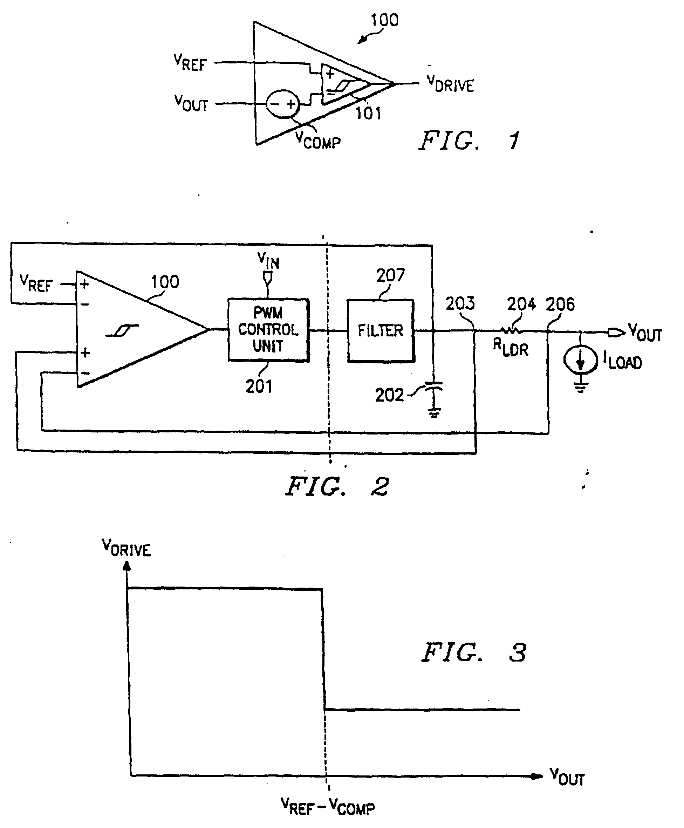

FIG. 1 shows a comparator 100 itself comprising a comparator 101 that is illustrated as a hysteretic comparator but also may be implemented as a conventional (i.e., non-hysteretic) comparator. A non-inverting input of comparator 101 is coupled to receive the reference voltage signal $V_{REF}$. As shown in FIG. 1, the compensation voltage $V_{COMP}$ is subtracted from the $V_{OUT}$ signal before it is applied to an inverting input of comparator 101. In this manner, $V_{COMP}$, the voltage droop sense circuitry used to generate $V_{COMP}$, and any wiring and I/O pin capacitance used to couple the droop voltage to comparator 100 are buffered from $V_{REF}$.

FIG. 2 shows comparator 100 as a four-input summing comparator 100. The circuit operates fundamentally as a regulator comprising two distinct regulator elements. A first regulator element is designed to control the average output voltage while a second distinct regulator is designed to compensate for voltage loss between the regulator output and the load circuit. The average output voltage is controlled by comparing a reference voltage ($V_{REF}$) to the output voltage ($V_{OUT}$). The voltage loss compensation is controlled by a $V_{COMP}$ voltage applied to separate input terminals of comparator 100. In this manner each of the regulator elements in comparator 100 is designed to meet the needs of average DC level control and voltage loss compensation control. Significantly, because the two regulator elements are formed on a single integrated circuit the component devices are parametrically matched to provide superior performance.

Comparator 100 generates a pulse width modulated (PWM) signal (labeled $V_{DRIVE}$ in FIG. 1) coupled to PWM control unit 201. PWM control unit 201 chops $V_{IN}$ into a square wave having a duty cycle determined by the $V_{DRIVE}$ signal. The square wave signal is applied to a low pass filter described hereinbelow to generate a DC voltage at node 202 that is lower than $V_{IN}$ in the examples. The output voltage on node 203 may be higher than $V_{IN}$ in some circuits with relatively low output current. The dashed line in FIG. 2 indicates the regulator integrated circuit (IC) boundary in the particular example herein. Filter capacitor 202 may be integrated into the regulator IC in which case it is essentially a part of the low pass filter within PWM control unit 201, or may be provided as an external filter capacitor to meet the needs of a particular application.

As shown in FIG. 2, regulator IC output node 203 is coupled to a load circuit at node 206 that draws a current $I_{LOAD}$ through a parasitic load impedance ($R_{LDR}$) 204. Load impedance 204 comprises the sum (real and imaginary) of all impedance causing devices in the coupling between output node 203 to load node 206. These devices include the parasitic impedance of wiring, device leakage, and in some cases real devices such as sense and current limit resistors. These examples are only some of the impedance causing devices that may be included in any particular circuit. Significantly, it is rarely possible to characterize the value of parasitic impedance 204 until a circuit board or system is fully designed and simulated. Hence, the regulator IC designer preferably allows a user to customize the compensation provided to counter the effect of parasitic load resistance 204.

The voltage loss across parasitic impedance 204 ($V_{DROOP}$) varies with $I_{LOAD}$ and in some cases with switching frequency. Hence, $V_{DROOP}$ can be estimated by characterizing the value of parasitic impedance 204 after circuit layout, and measuring $I_{LOAD}$ using current sensing transistors or resistors (not shown). The voltage drop across the sensing device can be coupled to the compensation inputs of comparator 100. Alternatively as shown in FIG. 2, $V_{DROOP}$ can be sensed directly by coupling voltage sense lines to regulator output node 203 and load node 206. By buffering the circuitry used to sense $V_{DROOP}$ from $V_{REF}$, the even if long (i.e., high capacitance) voltage sense lines are used, the integrity of $V_{REF}$ will not be compromised. Similarly, the capacitance associated with external I/O pins used to sense $V_{DROOP}$ is isolated from $V_{REF}$ and so will have minimal impact on performance (i.e., noise). These are significant advantages.

The voltage at which the binary output of comparator 100 switches is referred to as the "trip-point". The trip-point is determined by a combination of $V_{REF}$ and $V_{COMP}$ as shown in FIG 3.

The trip-point of comparator 100 is offset from $V_{REF}$ by an amount equal to $V_{COMP}$. $V_{COMP}$ is a dynamic value that depends on the actual value of $V_{DROOP}$.

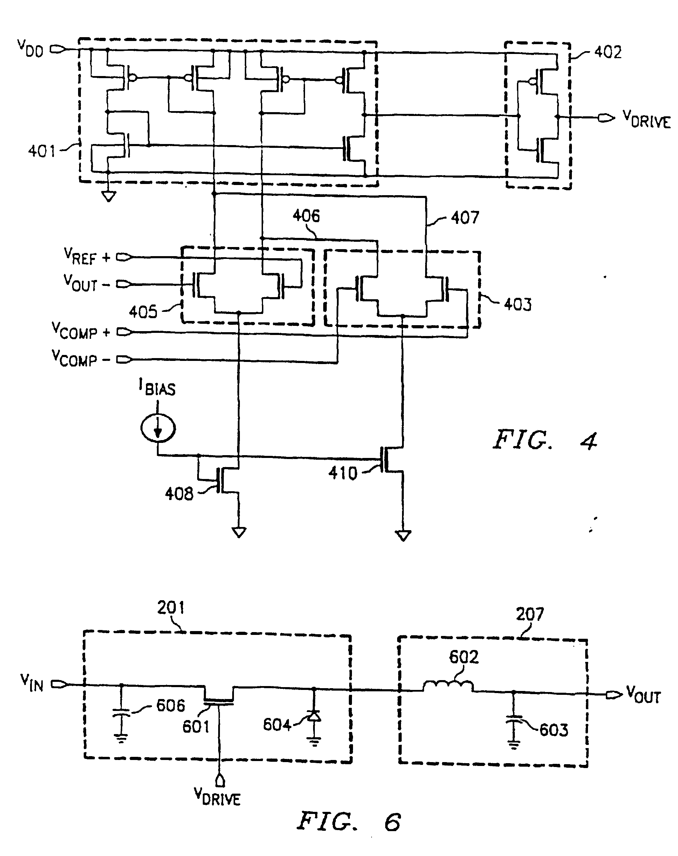

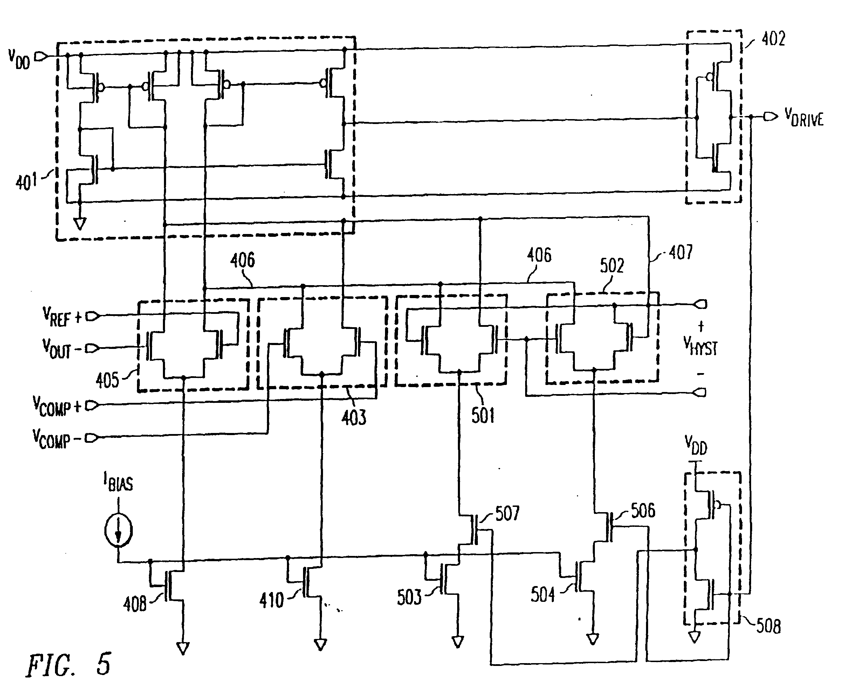

FIG. 4 illustrates a basic CMOS implementation of comparator 100. The implementations shown in FIG. 4 - FIG. 6 are provided for example only. Other embodiments of the invention may be implemented in other technologies including bipolar and BiCMOS technologies, and may use circuits having a greater or lesser number of components to realize the functionality described herein. Accordingly, these other implementations are equivalent to the specific implementations described herein.

Comparator block 401 comprises a CMOS comparator accepting a DC input voltage such as $V_{DD}$ that is different from the desired output voltage $V_{OUT}$. $V_{DD}$ is typically a regulated voltage and may be higher or lower than $V_{OUT}$ although it is higher than $V_{OUT}$ in the particular example herein. The trip-point of comparator 401 is set by the signal (i.e., voltage and/or current) on summing nodes 406 and 407 as set by input differential pairs 403 and 405. Transistors 408, and 410 serve as matched current sources for each of input differential pairs 405 and 403 respectively. Output buffer 402 is implemented as a CMOS inverting buffer having an inverting output stage comprising transistors sized to adequately drive the $V_{DRIVE}$ signal. Output buffer 402 is switched by the output of the comparator block 401.

Input pair 405 accepts the $V_{REF}$ signal on its non-inverting (+) input and the $V_{OUT}$ signal on its inverting input. A first output of input pair 405 is coupled to summing node 406 whereas a second output of input pair 405 is coupled to summing node 407. Input pair 403 accepts the $V_{COMP}$ signal from node 206 (shown in FIG. 2) on its inverting input and the $V_{COMP}$ signal from node 203 on its non-inverting input. In operation, differential input stage 405 and stage 403 operate in parallel (i.e.,

at the same time) to dynamically set the signals on summing nodes 406 and 407. In this manner, any latency added by differential input stage 403 is not cumulative with the inherent latency of differential input stage 405. This feature reduces latency making the regulator fast and accurate.

FIG. 5 illustrates an alternative comparator 100 that includes functionality for user programming of a hysteresis voltage. The benefits of the above-described embodiments can be especially significant in hysteretic DC-DC converters where the accuracy and speed of the comparator are paramount. The embodiment shown in FIG. 5 includes an accurate and fast means for enabling a user to program a hysteresis level of the comparator. In the embodiment shown in FIG. 5 components bearing similar identification as FIG. 4 are substantially equivalent in function and construction and so will not be described again in the following for the sake of brevity.

The summing signal (i.e., voltage and/or current) on summing nodes 406 and 407 is set by input differential pairs 403, 405 in combination with input pairs 501 and 502. Transistors 503 and 504 serve as matched current sources for each of input differential pairs 501 and 502 in a manner akin to transistors 408 and 410 described hereinbefore. In this embodiment, the $V_{DRIVE}$ signal generated by output buffer 402 is coupled back to inverter 508 and mode control switch 506. The output of inverter 508 is coupled to mode control switch 507. Mode control switches 506 and 507 in cooperation with inverter 508 selectively enable one or the other of input pairs 501 and 502 based upon the current binary value of $V_{DRIVE}$.

Input pair 501 accepts the $V_{HYST+}$ signal on its inverting input and the $V_{HYST-}$ signal on its non-inverting input. Input pair 502 accepts the $V_{HYST-}$ signal on its inverting input and the $V_{HYST+}$ signal on its non-inverting input. In operation, the $V_{DRIVE}$ signal selectively enables one or the other of input pairs 501 and 502. In the example shown in FIG. 5, a logic HIGH on the $V_{DRIVE}$ line enables switch 506 and disables switch 507. In this first mode, input pair 501 is disabled and does not affect the voltage on summing nodes 406 and 407. In the first mode $V_{HYST}$ is added to the signal components contributed by $V_{REF}$-$V_{COMP}$ to set the trip-point of comparator unit 401. In contrast, a logic LOW on the $V_{DRIVE}$ line enables switch 507 and disables switch 506. In this second mode, input pair 502 is disabled and does not affect the voltage on summing nodes 406 and 407. In the second mode $V_{HYST}$ is subtracted from the signal components contributed by $V_{REF}$-$V_{COMP}$ to set the trip-point of comparator unit 401.

As in the embodiment shown in FIG. 4, all of the input pairs 403, 405, 501 and 502 contributing to the summing signal on summing nodes 406 and 407 operate in parallel so that their individual latencies are not cumulative. Also, the integrity, quality and accuracy of $V_{REF}$ are not compromised because the signals are combined at the comparator level (i.e., at summing nodes 406 and 407) and not combined in series with the $V_{REF}$ voltage generator circuitry.

FIG. 6 illustrates exemplary PWM control unit 201 for receiving the $V_{DRIVE}$ signal and generating a regulated DC output voltage $V_{OUT}$. The example of FIG. 6 shows a basic buck regulator output stage in which $V_{DRIVE}$ drives a switch 601 implemented as an n-channel MOSFET. The buck regulator of FIG. 6 is used to step an input voltage $V_{IN}$ down to a lower level. Switch 601 chops the input DC voltage $V_{IN}$ into a square wave. This square wave is then converted back into a DC voltage of lower magnitude by the low pass filter comprising inductor 602 and capacitor 603. Capacitor 603 may be substituted by or combined with capacitor 202 shown in FIG. 2. Diode 604 shunts excess voltage to ground while capacitor 606 serves as a preliminary filter to smooth variations in $V_{IN}$. The duty cycle of the square wave relates the output voltage to the input voltage by the equation:

$$V_{OUT} = V_{IN} \times \frac{t_{on}}{t_{on} + t_{off}}$$

where $t_{on}$ and $t_{off}$ describe the duty cycle of $V_{DRIVE}$.

Although the invention and its embodiments have been described and illustrated with a certain degree of particularity, it is understood that the present disclosure has been made only by way of example, and that numerous changes in the combination and arrangement of parts can be resorted to by those skilled in the art without departing from the spirit and scope of the invention.

**Claims**

1.  A DC-DC converter for providing power to a load circuit, the DC-DC converter comprising:

     an input node for receiving an input voltage $V_{IN}$;
     a pulse width modulation (PWM) unit coupled to chop $V_{IN}$ into a square wave under control of a $V_{DRIVE}$ signal;
     an output stage for converting the chopped $V_{IN}$ to an output voltage $V_{OUT}$ coupled to an output node;
     a parasitic impedance coupled between the output node and the load circuit;
     a reference voltage generator for providing a voltage $V_{REF}$;
     an offset voltage generator having an output coupled to provide a voltage $V_{COMP}$ representing a voltage drop across the parasitic impedance ($V_{LDR}$); and
     a comparator unit coupled to receive $V_{OUT}$, $V_{REF}$, and $V_{COMP}$ and coupled to the PWM unit to provide the $V_{DRIVE}$ signal.

2.  The DC-DC converter of claim 1, wherein the comparator unit further comprises:

     a first differential input stage for generating a signal coupled to a summing node determined from a difference between $V_{OUT}$ and $V_{REF}$; and
     a second differential input stage for generating a signal coupled to the summing node determined from the voltage drop across the parasitic impedance.

3.  The DC-DC converter of claim 1 or claim 2, comprising at least one buffer stage arranged to isolate a voltage drop across the parasitic impedance from the reference voltage generator.

4.  The DC-DC converter of claim 1, 2 or 3, wherein the comparator unit further comprises a summing device for subtracting $V_{COMP}$ from $V_{OUT}$ prior to providing the $V_{DRIVE}$ signal.

5.  The DC-DC converter of any preceding claim, wherein the first and second input stages each have a non-inverting output and an inverting output, and the summing node further comprises:

     a first summing node coupled to the non-inverting output of the first input stage, the non-inverting output of the second input stage, and the inverting output of the third input stage; and
     a second summing node coupled to the inverting output of the first input stage, the inverting output of the second input stage, and the non-inverting output of the third input stage.

6.  The DC-DC converter of claim 5, wherein the hysteretic comparator further comprises:

     a differential comparator generating a binary signal from a difference between the first and second summing nodes; and
     an output driver coupled to receive the binary signal from the differential comparator and generate the $V_{DRIVE}$ signal.

7.  The DC-DC converter of claim 2, or any one of claims 3 to 6 when appended thereto, further comprising:

     a hysteresis voltage generator providing a voltage $V_{HYST}$ representing a desired amount of hysteresis; and
     a control circuit for controllably combining $V_{HYST}$ with a voltage on the summing node in response to the $V_{DRIVE}$ signal.

**8.** The DC-DC converter of claim 7, further comprising:

a third differential input stage for generating a signal coupled to the summing node determined from a positive value of $V_{HYST}$;
a fourth differential input stage for generating a signal coupled to the summing node determined from a negative value $V_{HYST}$; and
a control device coupled to selectively enable the third and fourth differential input stages to select among a first mode and second mode.

**9.** The DC-DC converter of any preceding claim, wherein the comparator unit further comprises:

a first comparator for generating a signal coupled to a summing node determined from a difference between $V_{OUT}$ and $V_{REF}$; and
a second comparator for generating a signal coupled to the summing node determined from a difference between $V_{OUT}$ and a sensed loaded $V_{OUT}$ available at the load circuit, wherein the first and second comparators are arranged to operate in parallel such that time delays associated with each of the first and second comparators are non-cumulative.

**10.** A method for providing power to a load circuit, the load circuit coupled to a regulator output node supplying an output voltage $V_{OUT}$ through a connection having a characteristic parasitic impedance, the method comprising the steps of:

providing an input voltage $V_{IN}$;
providing a reference voltage $V_{REF}$;
comparing $V_{OUT}$ to $V_{REF}$ to determine a first difference signal;
determining a loaded output voltage $V_{OUT(LOAD)}$ at the load circuit;
comparing $V_{OUT}$ to $V_{OUT(LOAD)}$ to determine a second difference signal;
subtracting the second difference signal from the first difference signal to generate a trigger signal; and
generating a pulse width modulated signal by amplifying the trigger signal.

**11.** A circuit including a DC-DC converter, the circuit comprising:

an input node receiving an input voltage $V_{IN}$;
a pulse width modulation (PWM) unit coupled to chop $V_{IN}$ into a square wave under control of a $V_{DRIVE}$ signal;
a low pass filter coupled to receive the chopped $V_{IN}$ and generate output voltage $V_{OUT}$ coupled to an output node;

a load circuit having a node coupled to receive power from the output node;
conductive wiring having a parasitic impedance coupled between the output node of the low pass filter and the load circuit;
a reference voltage generator providing a voltage $V_{REF}$;
an offset voltage generator having an output coupled to provide a voltage $V_{COMP}$ representing a voltage drop across the parasitic impedance ($V_{LDR}$); and
a comparator unit coupled to receive $V_{OUT}$, $V_{REF}$, and $V_{COMP}$ and coupled to the PWM unit to provide the $V_{DRIVE}$ signal.

FIG. 1

FIG. 2

FIG. 3

8

EP 0 928 056 A2

FIG. 4

FIG. 6

9

FIG. 5

EP 0 928 056 A2